Europäisches Patentamt

(19) European Patent Office

Office européen des brevets

(11) Numéro de publication: **0 058 600**
**B1**

(12) **FASCICULE DE BREVET EUROPEEN**

(45) Date de publication du fascicule du brevet:
**22.05.85**

(51) Int. Cl.⁴: **H 04 M 17/02,** H 04 M 11/04

(21) Numéro de dépôt: **82400215.8**

(22) Date de dépôt: **08.02.82**

(54) Circuit d'alarme pour système de surveillance de postes téléphoniques publics à prépaiement.

(30) Priorité: **12.02.81 FR 8103234**

(43) Date de publication de la demande:
**25.08.82 Bulletin 82/34**

(45) Mention de la délivrance du brevet:
**22.05.85 Bulletin 85/21**

(84) Etats contractants désignés:
**AT BE CH DE LI**

(56) Documents cités:
**CH - A - 473 433**
**FR - A - 2 446 519**
**US - A - 3 631 433**
**US - A - 3 813 500**
**US - A - 4 039 768**
**US - A - 4 206 321**

(73) Titulaire: **Etablissements M. LAUDREN & Compagnie S.A., Rue Trudaine, Z.I. Kerpont-Bras, F-56600 Lanester (FR)**

(72) Inventeur: **Montfort, Roger, 17, rue Alphonse Tanguy, F-56100 Lorient (FR)**

(74) Mandataire: **Le Guen, Louis François, Cabinet Louis Le Guen 1, avenue Edouard VII B.P. 91, F-35802 Dinard Cédex (FR)**

## Description

La présente invention concerne un circuit d'alarme pour systèmes de surveillance de postes téléphoniques publics à prépaiement, le circuit d'alarme comportant un oscillateur transmettant en ligne un signal de dérangement quand certaines conditions anormales surviennent dans le poste public.

L'accroissement du parc des postes téléphoniques publics à prépaiement, tels que les appareils muraux dits «PUBLIPHONES», a amené l'Administration des Télécommunications à organiser un système assurant leur surveillance automatique. En effet, ces postes, en dehors des pannes techniques normales et inévitables, sont l'objet de dégradations simplement stupides, telles que celles qui consistent à arracher le combiné ou à couper la ligne, ou de dégradations plus subtiles consistant par exemple à empêcher les impulsions de taxe d'atteindre le poste, ou même d'effractions en vue du vol de la caisse contenue dans le poste ou des pièces restées visibles dans les canaux.

Un tel système de surveillance comprend des circuits individuels d'alarme installés dans les postes et des unités de réception des signaux d'alarme et de traitement de ces signaux, ces unités étant installées dans les centraux téléphoniques auxquels les postes sont rattachés.

Un objet de la présente invention consiste à prévoir un circuit d'alarme destiné à être installé dans un poste public à prépaiement et capable de transmettre à une unité de réception un certain nombre de signaux identifiant ou permettant d'identifier plusieurs états possibles du poste, étant entendu que les unités de réception ne font pas partie de la présente invention et ne seront pas décrites en détail dans la suite.

Dans le brevet US-A 4 039 768, il est décrit un système de surveillance de postes téléphoniques publics à prépaiement qui comporte un oscillateur dont la sortie est reliée au primaire d'un transformateur dont le secondaire est relié respectivement par deux condensateurs aux fils de ligne du poste public en amont des contacts de connexion dudit poste.

Dans ce circuit d'alarme connu, le signal de l'oscillateur n'est transmis en ligne que quand une anomalie d'une certaine durée se présente dans le poste public.

Par ailleurs, dans le brevet US-A 4 206 321, il est prévu un circuit d'alarme de poste téléphonique public qui comporte un contact dont l'état dépend de la présence ou non de la caisse dans le poste et qui est associé à un oscillateur. Toutefois, là encore, le signal de sortie de l'oscillateur n'est transmis en ligne que quand la caisse est absente.

Un objet de la présente invention consiste à prévoir un circuit d'alarme rendant plus de services que les circuits connus. Notamment, le circuit d'alarme de l'invention transmet un signal quand le poste est au repos dans des conditions correctes de fonctionnement. On comprendra qu'une des qualités d'un tel circuit doit être sa faible consommation.

Les objets de l'invention mentionnés ci-dessus sont atteints par la mise en œuvre des combinaisons de moyens définies dans la partie caractérisante de la revendication principale complétée par les revendications dépendantes.

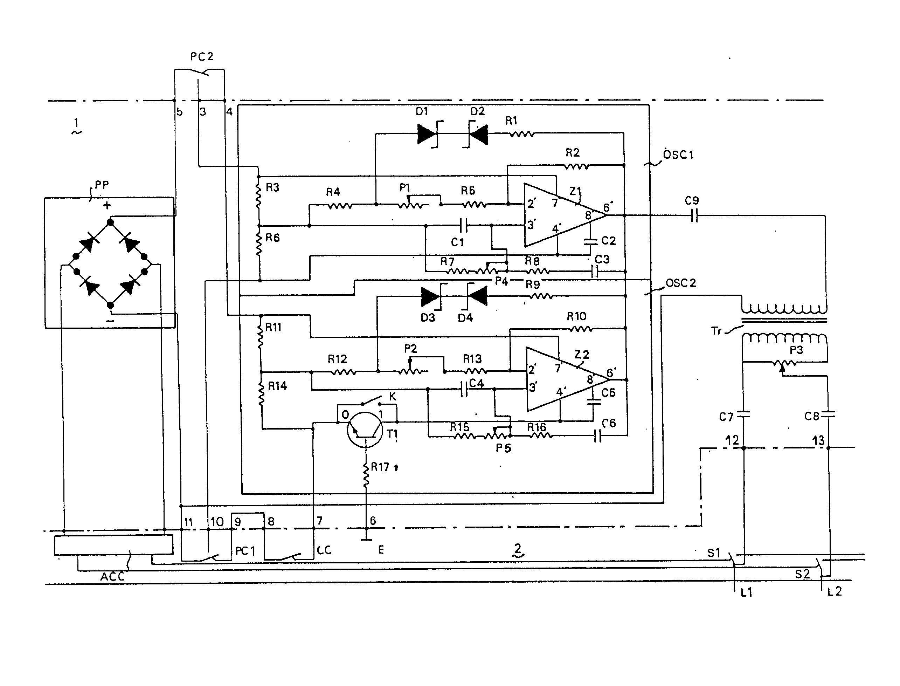

Les caractéristiques de l'invention apparaîtront plus clairement à la lecture de la description suivante d'un exemple de réalisation, ladite description étant faite en relation avec le dessin de la figure unique jointe.

Dans la figure unique, le circuit d'alarme 1 est associé à un poste public à prépaiement 2 qui est relié à un central (non montré) par une ligne téléphonique L1–L2. Dans le poste, on n'a représenté que les contacts qui influencent le fonctionnement du circuit d'alarme. On trouvera une description détaillée d'un poste public du type «PUBLIPHONE» dans les notices techniques des constructeurs français de ces matériels, tels que les sociétés Télic, Landis et Gyr, etc. Ainsi, dans le poste, on a prévu, en plus des contacts de fourche classiques, un microcontact CC indiquant au repos le raccrochage du combiné téléphonique et deux microcontacts inverseurs PC1 et PC2 contrôlant la présence de la caisse par leurs contacts de travail. Par ailleurs, le circuit d'alarme 1 est également relié en E à la terre du poste public. Enfin, les fils de lignes L1 et L2 sont reliés au circuit d'alarme 1, en amont, vu du central, des contacts de travail s1 et s2 qui sont fermés pour boucler la ligne sur le poste dans le cas d'un appel. A titre d'information, on rappelle que les contacts s1 et s2 sont fermés quand deux conditions sont remplies, c'est-à-dire le décrochage du combiné et l'introduction de la taxe de base. La source d'alimentation du circuit d'alarme 1 est constituée par la charge d'un condensateur ACC monté en parallèle sur les fils de ligne L1 et L2 quand le poste est au repos, c'est-à-dire les contacts s1 et s2 au repos. Quand une communication est établie, avec s1 et s2 au travail, le condensateur ACC se trouve relié à un convertisseur continu-continu, non montré, alimenté par le courant de ligne.

Dans le circuit d'alarme, le fil de ligne L1 est relié, par la borne 12 et un condensateur C7, à une extrémité de l'enroulement secondaire d'un transformateur de séparation Tr. L'autre extrémité du secondaire de Tr est reliée à la première extrémité par un potentiomètre P3 dont le curseur est relié au fil L2, par le condensateur C8 et la borne 13.

Le circuit d'alarme comprend deux oscillateurs OSC1 et OSC2 dont les sorties sont reliées en parallèle, à travers un condensateur de liaison C9 à une extrémité du primaire du transformateur. Tr, dont l'autre extrémité est reliée à la borne – d'un pont PP dont le rôle est de polariser l'alimentation.

L'oscillateur OSC1 comprend un amplificateur opérationnel Z1 faisant partie d'un montage en pont de Wien. A titre indicatif, l'amplificateur Z1 peut être un amplificateur LM208G commercialisé par la société MOTOROLA. Dans le dessin, les bornes 2′, 3′, 4′, 6′, 7′ et 8′ correspondent à celles de ce circuit. La borne 2′ est reliée au point commun de deux résistances R3 et R6, par une résistance R5, un potentiomètre P1 et une résistance R4 en série. La borne 3′ est reliée au point commun de R3 et R6, par un condensateur C1. La borne 7′ ainsi que l'autre borne de R3 sont reliées à la borne d'entrée 3. La borne 4′ ainsi que l'autre borne de R6 sont reliées à la borne d'entrée 10. La sortie 6′, qui est reliée au condensateur C9, est encore reliée à la borne 2′ par une résistance R2, au point commun de la résistance R4 et du potentiomètre P1 par une résistance R1 et deux diodes Zener D1 et D2 polarisées en sens inverse, à la borne 3′ par un condensateur C3 et une résistance R8. En parallèle sur les bornes du condensateur C1, sont prévus en série un potentiomètre P4 et une résistance R7. Enfin les bornes 4′ et 8′ sont reliées par un condensateur C2.

L'oscillateur OSC2 comprend également un amplificateur opérationnel Z2 qui fait partie d'un montage en pont de Wien. L'amplificateur Z2 est de préférence du même type que l'amplificateur Z1. Sa borne 2′ est reliée au point commun de deux résistances R11 et R14, par une résistance R13, un potentiomètre P2 et une résistance R12 en série. La borne 3′ est reliée au point commun de R11 et R14, par un condensateur C4. La borne 7′ ainsi que l'autre borne de R11 sont reliées à la borne d'entrée 4. L'autre borne de R14 est reliée à la borne d'entrée 7. La borne 4′ est également reliée à la borne d'entrée 7, d'une part, par un contact K et, d'autre part, par le circuit collecteur-émetteur d'un transistor T1. La base de T1 est reliée à la borne 6 par une résistance R17. La sortie 6′, qui est aussi reliée au condensateur C9, est encore reliée à la borne 2′ par une résistance R10, au point commun à R12 et P2 par une résistance R9 et deux diodes Zener D3 et D4 polarisées en sens inverse, à la borne 3′ par un condensateur C6 et une résistance R16. En parallèle sur les bornes du condensateur C4, sont prévus en série un potentiomètre P5 et une résistance R15. Enfin les bornes 4′ et 8′ sont reliées par un condensateur C5.

Les bornes 3 et 4 sont reliées aux contacts fixes de l'inverseur PC2 dont le contact mobile est relié à la borne + du pont PP, par la borne 5. Les bornes 9 et 10 sont reliées aux contacts fixes de l'interrupteur PC1 dont le contact mobile est relié à la borne – de PP, par la borne 11. La borne 7 est reliée à une borne 8 par le contact de repos CC et la borne 8 est reliée directement à la borne 9. La borne 6 est reliée à la terre E du poste.

Quand le combiné du poste est raccroché, le contact CC, fermé, relie les bornes 7 et 8. Quand il est décroché, il coupe la liaison entre les bornes 7 et 8. Quand la caisse du poste public est en place, les contacts inverseurs PC1 et PC2 sont actionnés et relient respectivement les bornes 11 et 5 aux bornes 9 et 4. Quand la caisse est enlevée, ils relient respectivement les bornes 11 et 5 aux bornes 3 et 10.

On va maintenant décrire le fonctionnement du circuit d'alarme. On va d'abord supposer que le poste fonctionne avec des impulsions de taxe à 50 Hz, ce qui implique que E est relié à la terre. Le contact K est alors ouvert. Quand le poste est au repos, le combiné est raccroché, la tension + de PP est appliquée, par 5, PC2 et 4, au point commun à R11 et la borne 7′ de Z2, d'une part, et la tension – de PP est appliquée, par 11, PC1, 9, 8, CC et 7, à R14 et, par T1, à la borne 4′ de Z2, d'autre part. La base de T1 étant reliée à la terre par R17, le transistor T1 conduit. Donc l'oscillateur OSC2 fonctionne tandis que l'oscillateur OSC1 est isolé. Les valeurs des composants de OSC2 ont été choisies de manière que sa sortie délivre un signal à 800 Hz qui est appliqué, par C9, au transformateur Tr, et donc aux fils de ligne L1 et L2. Donc l'unité de réception du central reçoit en permanence du 800 Hz.

Dès qu'un utilisateur décroche le combiné du poste, le contact CC change d'état, l'oscillateur OSC2 n'est plus alimenté et ne délivre plus le signal à 800 Hz.

Si l'appelant a introduit la taxe de base dans le poste à prépaiement, les contacts s1 et s2 passent au travail et établissent la connexion du poste avec la ligne. Au central, l'unité de réception détecte le passage du courant de ligne et interprète cette information comme un fonctionnement normal du poste téléphonique.

Si, entre le moment du décrochage du combiné et le changement d'état de S1 et S2, il se passe un temps plus long qu'une constante de temps prévue dans l'unité de réception, celle-ci va constater l'absence d'émission du signal à 800 Hz et l'absence du courant de ligne, si bien qu'une alarme va être déclenchée indiquant un combiné décroché par erreur. Si le combiné est raccroché pendant cette constante de temps, sans changement d'état de S1 et S2, l'oscillateur OSC2 émet de nouveau de 800 hZ en ligne et il n'y a pas d'alarme.

Si le poste est attaqué et que l'on enlève la caisse, les contacts inverseurs PC1 et PC2 changent d'état. La tension + de PP est maintenant appliquée, par 5, PC2 et 3, au point commun à R3 et à la borne 7′ de Z1, d'une part, et la tension – est appliquée, par 11, PC1 et 10, au point commun à R6 et la borne 4′ de Z1, d'autre part. L'oscillateur OSC1 fonctionne alors que l'oscillateur OSC2 est bloqué. Les valeurs des composants de OSC1 sont choisies pour qu'il délivre en 6′ un signal à 2300 Hz qui est envoyé en ligne. L'unité de réception délivre donc une alarme. A noter que, si la caisse est relevée par un préposé, cette alarme est interprétée comme le passage normal du préposé.

Enfin, si la terre est coupée dans le poste, ce qui ne permet plus le traitement des impulsions à 50 Hz dans le poste, la base du transistor T1 est isolée, il ne conduit plus et l'émission du 800 Hz cesse.

Dans le cas oú on utilise des impulsions de taxe à 12 kHz, la terre E n'est pas nécessaire et on ferme le contact K.

De la description qui précède, il apparaît que le circuit d'alarme, suivant l'invention, permet de détecter un certain nombre de défauts du poste, auxquels il faut ajouter la coupure de la ligne L1–L2, qui bien entendu coupe l'émission du 800 Hz vers le central.

Par ailleurs, le poste public étant la majeure partie du temps à l'état de repose, le circuit d'alarme émet du 800 Hz en ligne. Il faut bien entendu que le niveau de cette émission soit suffisant pour qu'il soit reçu au central. Mais il faut également que la consommation soit la plus faible possible. Ce résultat est atteint dans le circuit d'alarme par le choix d'un montage en pont de Wien qui, avec les composants choisis, assure une consommation ne dépassant pas 500 microampères.

## Revendications

1. Circuit d'alarme pour système de surveillance de poste téléphonique public à prépaiement, comportant un premier oscillateur (OSC1) dont la sortie est reliée au primaire d'un transformateur (TR) dont le secondaire est relié respectivement par deux condensateurs (C7, C8) aux fils de ligne (L1, L2) du poste téléphonique public en amont des contacts de connexion (s1, s2) dudit poste, caractérisé en ce qu'il comporte un second oscillateur (OSC2) dont la sortie est montée comme celle dudit premier oscillateur (OSC1), le premier et le second oscillateurs (OSC1, OSC2) étant accordés sur deux fréquences vocales différentes, le circuit comprenant encore sur les deux fils d'alimentation des deux oscillateurs (OSC1, OSC2) deux microcontacts inverseurs (PC1, PC2) dont l'état dépend de la présence ou non de la caisse dans le poste et qui commutent l'alimentation vers l'oscillateur (OSC2) quand la caisse est présente et l'autre (OSC1) quand la caisse est absente.

2. Circuit d'alarme suivant la revendication 1, caractérisé en ce qu'un fil de l'alimentation de l'oscillateur (OSC2), qui est en service quand la caisse du poste est présente, comporte encore un contact de repos (CC) qui est directement ouvert par le décrochage de la fourche du combiné du poste.

3. Circuit d'alarme suivant la revendication 1 ou 2, caractérisé en ce qu'un fil de l'alimentation de l'oscillateur (OSC2), qui est en service quand la caisse est présente dans le poste, comporte encore, en série, un commutateur électronique (T1) se composant du circuit collecteur-émetteur d'un transistor dont la base est reliée à la terre du poste public.

4. Circuit d'alarme suivant l'une des revendications 1 à 3, caractérisé en ce que les oscillateurs (OSC1, OSC2) sont chacun montés en pont de Wien.

5. Circuit d'alarme suivant l'une des revendications 1 à 4, caractérisé en ce que les fils d'alimentation du circuit d'alarme sont reliés aux bornes du condensateur tampon (ACC) classique des postes publics.

## Patentansprüche

1. Alarmschaltung für Überwachungssysteme für öffentliche Münzfernsprecher mit einem ersten Oszillator (OSC1), dessen Ausgang an die Primärwicklung eines Transformators (TR) gelegt ist, dessen Sekundärwicklung entsprechend über zwei Kondensatoren (C7, C8) an die Leitungen (L1, L2) des öffentlichen Fernsprechers vor dessen Anschlusskontakten (s1, s2) geschaltet ist, dadurch gekennzeichnet, dass sie einen zweiten Oszillator (OSC2) hat, dessen Ausgang gleich dem Ausgang des ersten Oszillators (OSC1) geschaltet ist, dass der erste und der zweite Oszillator (OSC1, OSC2) auf zwei verschiedene Hörfrequenzen abgeglichen sind, dass die Schaltung ferner in den beiden Speiseleitungen für die beiden Oszillatoren (OSC1, OSC2) zwei Umkehr-Mikroschalter (PC1, PC2) aufweist, deren Zustand davon abhängt, ob der Münzbehälter in der Fernsprechzelle vorhanden ist oder nicht, und dass durch die Umkehr-Mikroschalter die Speisung an den Oszillator (OSC2) geschaltet wird, wenn der Münzbehälter vorhanden ist und an den anderen Oszillator (OSC1) wenn der Münzbehälter fehlt.

2. Alarmschaltung nach Anspruch 1, dadurch gekennzeichnet, dass eine Speiseleitung zum Oszillator (OSC2), der in Betrieb ist, wenn der Münzbehälter vorhanden ist, ferner mit einem Ruhekontakt (CC) versehen ist, der direkt geöffnet wird durch Abnehmen des Hörers der Fernsprechzelle.

3. Alarmschaltung nach Anspruch 1 oder 2, dadurch gekennzeichnet, dass eine Speiseleitung für den Oszillator (OSC2), der in Betrieb ist, wenn der Münzbehälter vorhanden ist, ferner einen reihengeschalteten elektronischen Schalter (T1) aufweist, bestehend aus dem Emitter-Kollektor-Kreis eines Transistors, dessen Basis an Erde der öffentlichen Fernsprechzelle gelegt ist.

4. Alarmschaltung nach einem der Ansprüche 1–3, dadurch gekennzeichnet, dass jeder der Oszillatoren (OSC1, OSC2) in Form einer Wien-Brückenschaltung ausgebildet ist.

5. Alarmschaltung nach einem der Ansprüche 1–4, dadurch gekennzeichnet, dass die Speiseleitungen der Alarmschaltung an die Anschlüsse eines konventionellen Puffer-Kondensators (ACC) der öffentlichen Fernsprechzelle gelegt sind.

## Claims

1. An alarm circuit for public prepayment telephone station monitoring system, having a first oscillator (OSC1) the output of which is connected to the primary of a transformer (TR) the secondary of which is respectively connected through two capacitors (C7, C8) to the wires (L1, L2) of the public telephone station line before the connecting contacts (s1, s2) of said station, characterized in that it has a second oscillator (OSC2) the output of which is mounted like the first oscillator (OSC1) output, the first and second oscillators (OSC1, OSC2) being tuned at two different audio frequencies, the circuit also having on the two supply wires of the two oscillators (OSC1, OSC2) two inverter microswitches (PC1, PC2) the condition of which depends on wether or not the cash box is present in the station, those inverter microswitches switching the supply onto the oscillator (OSC2) when the cash box is present and onto the other (OSC1) when the cash box is absent.

2. An alarm circuit according to claim 1, characterized in that a supply wire to the oscillator (OSC2), that is in service when the station cash box is present, has also a resting contact (CC) that is directly opened by hooking off the station handset.

3. An alarm circuit according to claim 1 or 2, characterized in that a supply wire of the oscillator (OSC2), that is in service when the cash box is present, has also, serially mounted, an electronic switch (T1) comprised of the emitter-collector circuit of a transistor the base of which is connected to the ground of the public station.

4. An alarm circuit according to one of claims 1-3, characterized in that the oscillators (OSC1, OSC2) are each arranged as a Wien bridge circuit.

5. An alarm circuit according to one of claims 1-4, characterized in that the alarm circuit supply wires are connected to the terminals of a conventional public station buffer capacitor (ACC).